# FASCICULE DE BREVET EUROPEEN

(11) **EP 2 988 180 B1**
(45) Date de publication et mention de la délivrance du brevet: **15.05.2019**
(21) Numéro de dépôt: 14181642.1
(22) Date de dépôt: 20.08.2014
(51) Int. Cl.: G04G 21/08, G06F 3/044, H03K 17/96, G06F 3/041, H03K 17/94, B32B 7/12, B32B 17/06

(54) **Verre à touches capacitives pour un instrument électronique, et procédé pour sa fabrication**
Kapazitive Touchscreen-Glasscheibe für ein elektronisches Element, und ihr Herstellungsverfahren
Capacitive touch-sensitive glass for an electronic instrument, and method for manufacturing same

(43) Date de publication de la demande: 24.02.2016
(73) Titulaire: EM Microelectronic-Marin SA, 2074 Marin (CH)
(72) Inventeur: Hamm, Alain, 2523 Lignières (CH); Longa, Giovanni, 2000 Neuchâtel (CH)
(74) Mandataire: Giraud, Eric

(56) Documents cités:
- EP-A2- 2 273 349
- WO-A1-2014/010686
- US-A1- 2001 024 194
- US-A1- 2013 093 706
- US-A1- 2014 118 302
- US-B2- 8 805 517

## Description

L'invention concerne un verre à touches capacitives pour un instrument électronique portable, notamment pour une montre.

L'invention concerne également un procédé de fabrication d'un verre muni de touches capacitives pour un instrument électronique portable. Le verre comprend notamment un film isolant sur lequel sont réalisées des électrodes et au moins des pistes conductrices reliant respectivement chaque électrode à une portion de connexion.

Il faut comprendre comme instrument électronique, tout dispositif portable, tel qu'une montre-bracelet, un téléphone portable, un badge ou un autre appareil, qui peut être muni d'un écran ou cadran d'affichage d'une information au-dessus duquel est disposé un verre, qui ferme le boîtier de l'instrument.

La réalisation d'un verre muni d'une ou plusieurs électrodes transparentes en tant que touches capacitives pour équiper un instrument électronique est bien connue notamment dans le domaine de l'horlogerie ou des téléphones portables. Habituellement, plusieurs électrodes transparentes, qui constituent des touches capacitives, sont disposées sur une face intérieure du verre de l'instrument électronique, tel qu'une montre-bracelet. Ces touches capacitives sont reliées à un circuit électronique de traitement pour la commande ou le contrôle de fonctions de l'instrument électronique.

La réalisation de telles électrodes transparentes sur la face intérieure du verre est effectuée par un dépôt d'une couche d'oxyde conducteur, qui peut être conventionnellement un oxyde d'étain et d'indium (ITO), et par une gravure chimique de cette couche d'oxyde conducteur. L'épaisseur de la couche obtenue est comprise généralement entre 25 et 75 nm, et de préférence entre 45 et 55 nm. Chaque électrode transparente est reliée par une piste conductrice jusqu'à une portion de connexion en bordure du verre de l'instrument électronique pour être reliée, via un connecteur, au circuit électronique de traitement dans l'instrument électronique.

Le verre, qui peut être en matière plastique pour un instrument électronique, tel qu'une montre-bracelet, doit avoir une épaisseur suffisante pour résister à de fortes pressions externes, par exemple lorsque la montre est immergée. Si le verre, qui porte des électrodes transparentes sur sa face intérieure, doit avoir une épaisseur suffisante, cette forte épaisseur du verre peut nuire au bon fonctionnement du clavier à touches capacitives, ce qui est un inconvénient.

Dans le cas d'une montre à affichage de l'heure numériquement, des touches capacitives peuvent être réalisées dans le dispositif d'affichage à cristaux liquides. Cependant comme le boîtier d'une telle montre est fermé par un verre supplémentaire au dispositif d'affichage à cristaux liquides, une distance relativement élevée subsiste entre le doigt d'un utilisateur posé sur la face extérieure du verre et une électrode d'une touche capacitive à activer. Ceci constitue également un inconvénient.

La demande de brevet EP 2 273 349 A2 décrit un procédé pour fabriquer un élément transparent, tel qu'un verre, qui comprend des touches capacitives pour un instrument électronique portable. Un film isolant, qui porte des électrodes de touches capacitives reliées par des pistes conductrices, est disposé dans un moule. Une substance liquide est insérée dans le moule, afin d'être solidifiée et enrober au moins une partie du film isolant ayant les électrodes des touches capacitives. En sortie du moule, il est ainsi obtenu un verre avec des touches capacitives intégrées dans la matière solidifiée du verre. Cependant, il doit être prévu de bien positionner le film isolant dans le moule pour obtenir une bonne intégration des touches capacitives dans la substance solidifiée du verre. De plus, uniquement quelques substances peuvent être utilisées pour réaliser ce verre à touches capacitives intégrées, ce qui constitue des inconvénients.

La demande de brevet US 2013/0093706 A1 décrit un ensemble d'affichage. Cet ensemble comprend un dispositif d'affichage à cristaux liquides sur lequel est fixé un écran tactile. Le dispositif d'affichage comprend au moins un substrat de base sur lequel sont réalisées des lignes parallèles d'électrodes de commande d'affichage, une couche à cristaux liquides au-dessus des électrodes de commande et un substrat transparent supérieur. Des électrodes de détection tactile sont réalisées sur le substrat transparent supérieur. Ces électrodes de détection sont sous forme de lignes parallèles et perpendiculaires aux lignes des électrodes de commande. Au moins une couche isolante est placée sur les électrodes de détection. Cet ensemble est relativement compliqué et épais étant donné qu'il comprend un dispositif d'affichage et un écran tactile, ce qui constitue un inconvénient. De plus, la détection tactile dépend du potentiel de commande des électrodes de commande. Il ne peut donc pas servir comme verre à touches capacitives pour un instrument de petite dimension.

Dans la demande de brevet WO 2014/010686 A1, il est décrit principalement un procédé pour produire un substrat fonctionnel par l'intermédiaire d'un usinage laser afin de découper chaque substrat d'une plaque de base. Il est difficile de réaliser un verre à touches capacitives selon ce procédé.

L'invention a donc pour but de pallier aux inconvénients de l'état de la technique en fournissant un verre à touches capacitives pour un instrument électronique portable, qui soit suffisamment résistant tout en garantissant une grande sensibilité d'actions des touches capacitives activées notamment par un doigt d'un utilisateur.

A cet effet, l'invention concerne un verre à touches capacitives pour un instrument électronique portable, qui comprend les caractéristiques définies dans la revendication indépendante 1.

Des formes particulières d'exécution du verre à touches capacitives sont définies dans les revendications dépendantes 2 à 11.

Un avantage du verre à touches capacitives réside dans le fait que la fixation d'un film isolant à électrodes notamment transparentes sur une surface extérieure d'un verre d'un instrument électronique portable permet de pouvoir rendre très sensible toute action sur les touches capacitives par un doigt d'un utilisateur. Le verre de l'instrument peut ainsi être d'une épaisseur suffisante pour supporter toute force ou pression extérieure sans nuire au fonctionnement des touches capacitives. Ces touches capacitives sont reliées étanchement à travers le verre à un circuit électronique de traitement de l'instrument électronique. Pour ce faire, des trous métallisés sont réalisés à travers le substrat de base du verre.

A cet effet, l'invention concerne également un procédé de fabrication d'un verre à touches capacitives pour un instrument électronique portable, qui comprend les caractéristiques définies dans la revendication indépendante 12.

Des étapes particulières du procédé de fabrication sont définies dans les revendications dépendantes 13 à 16.

Selon l'invention, le film isolant portant les électrodes des touches capacitives est placé et fixé sur une surface extérieure du substrat de base du verre en étant guidé par un bord périphérique du substrat de base. Un autre film isolant de décoration peut encore être fixé sur le film isolant à touches capacitives par l'intermédiaire d'un film adhésif et suite à un laminage à chaud des films disposés les uns sur les autres. Un dispositif de connexion avec des trous dans le substrat de base et des tiges conductrices ou des dépôts conducteurs dans les trous est réalisé avant ou après au moins pour les tiges conductrices. Les électrodes du film isolant sont reliées électriquement au dispositif de connexion.

Les buts, avantages et caractéristiques du verre à touches capacitives pour un instrument électronique portable, et son procédé de fabrication apparaîtront mieux dans la description suivante sur la base de formes d'exécution non limitatives illustrées par les dessins sur lesquels :
les figures 1a et 1b représentent une vue de dessus et en coupe selon A-A de la figure 1a d'une forme d'exécution du verre à touches capacitives selon l'invention,
la figure 2 représente une vue tridimensionnelle en éclaté d'une première forme d'exécution du verre à touches capacitives selon l'invention, et
la figure 3 représente une vue tridimensionnelle en éclaté d'une seconde forme d'exécution du verre à touches capacitives selon l'invention.

Dans la description suivante, tous les éléments, qui constituent le verre à touches capacitives pour un instrument électronique portable, qui sont bien connus de l'homme du métier dans ce domaine technique, ne seront relatés que de manière simplifiée. Il est fait référence principalement dans la description suivante à un verre à touches capacitives destiné à équiper une montre-bracelet en tant qu'instrument électronique portable. Cependant, d'autres instruments électroniques portables peuvent être équipés du verre à touches capacitives de l'invention.

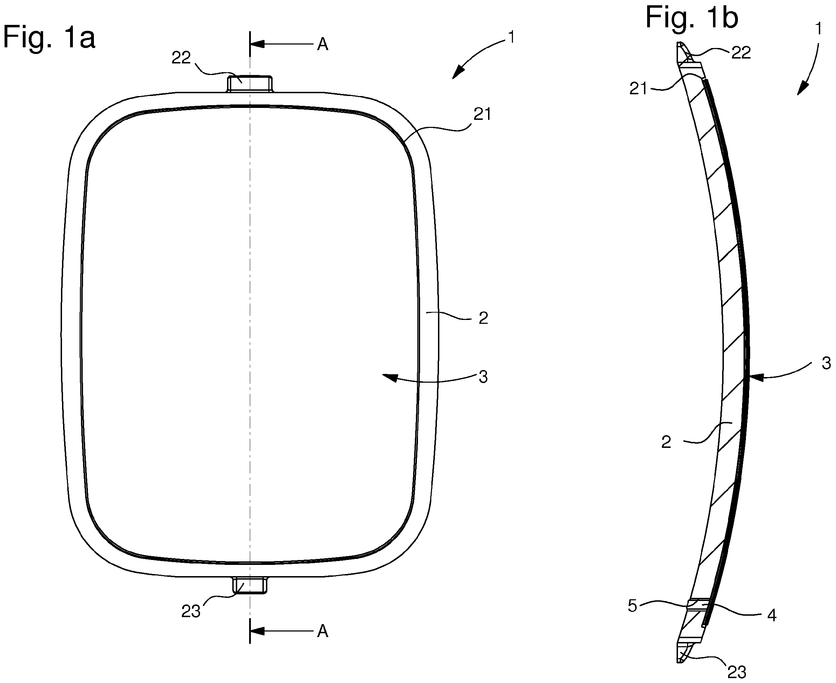

Aux figures 1a et 1b, il est représenté une vue de dessus et en coupe diamétrale d'une forme d'exécution d'un verre à touches capacitives obtenu par le procédé de fabrication décrit ci-après. Le verre 1 peut être de forme rectangulaire comme représenté à la figure 1a, mais également de forme circulaire ou d'une autre forme pour être monté de préférence au-dessus d'un cadran dans une montre-bracelet non représentée. Comme montré en coupe à la figure 1b, la forme générale du verre 1 peut être bombée, mais il peut être prévu que ce verre soit aussi de forme générale plane non représentée.

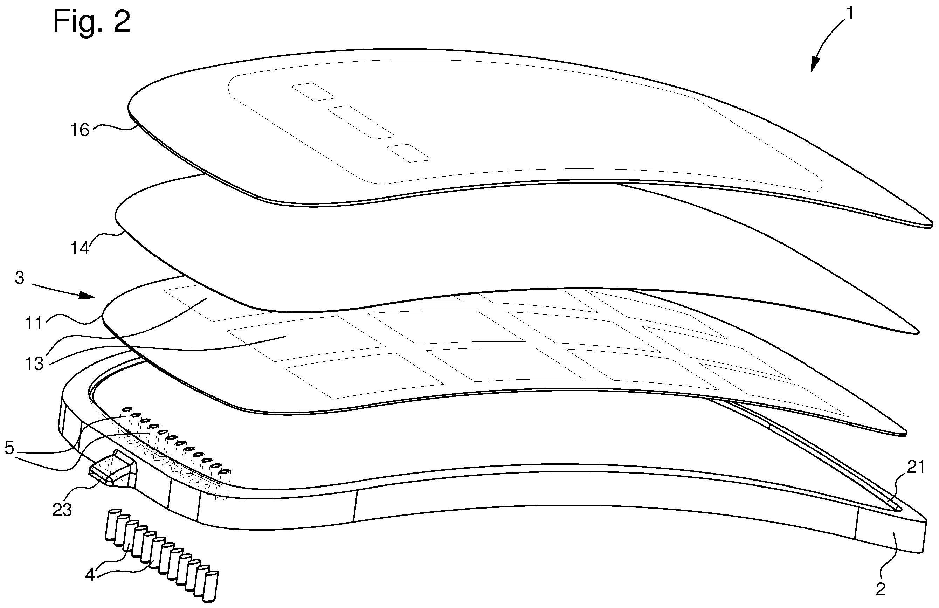

Le verre 1 comprend tout d'abord un substrat de base 2 et au moins un film isolant ou un ensemble de films ou couches 3 déposé ou fixé sur une surface extérieure du substrat de base 2. Le ou les films sont flexibles. Le film isolant 3 porte une ou plusieurs électrodes transparentes ou semi-transparentes en tant que touches capacitives comme expliqué ci-après en référence à la figure 2.

Le substrat de base 2 est conçu relativement rigide et d'épaisseur suffisante pour supporter des forces ou pressions externes importantes, lorsque le verre est monté dans la montre. Ce substrat de base 2 peut être de préférence transparent dans son intégralité ou au moins dans une portion centrale de manière à permettre la vision des indications horaires d'un cadran de la montre. Le substrat de base 2 peut également être teinté. Le substrat de base 2 peut être conçu en matériau plastique ou minéral.

Le substrat de base 2 comprend sur sa surface supérieure ou extérieure au moins un bord périphérique 21, qui est disposé en continu ou par secteurs en périphérie du substrat de base. Le bord est dimensionné par rapport aux dimensions du film isolant ou de l'ensemble des films ou couches 3 pour faciliter le montage du film isolant ou de chaque film ou couche successivement sur la surface extérieure du substrat de base. Ce bord sert donc aussi de guidage au placement du ou des films isolants à fixer à l'intérieur du bord périphérique 21.

Un faible écart entre la paroi intérieure du bord 21 et la périphérie de chaque film isolant 3 peut subsister après leur montage sur la surface extérieure du substrat de base. Cet écart peut être inférieur à 1 mm, par exemple de 0.1 mm pour un verre de montre de largeur supérieure à 20 mm. De plus, l'épaisseur du bord 21 est sensiblement la même que l'épaisseur de l'ensemble des films ou couches 3 fixé sur la surface extérieure du substrat de base 2 de manière à former un verre d'épaisseur uniforme.

Deux coins 22, 23 sont encore prévus notamment en périphérie du substrat de base 2 pour faciliter le montage du verre dans une boîte de montre. Ces deux coins sont disposés latéralement par exemple sur deux côtés opposés du substrat de base et de préférence au centre de chaque côté correspondant. Il peut s'agir des deux côtés du verre parallèles à chaque endroit de fixation d'un bracelet à la boîte de montre. Les deux coins 22, 23 peuvent encore être de dimension différente, par exemple avoir une longueur différente pour servir de détrompeur lors du montage du verre terminé sur la boîte de montre.

Dans le substrat de base 2, il est encore prévu un dispositif de connexion, qui est constitué de tiges conductrices 4 disposées dans une série de trous 5 réalisés à travers le substrat de base. Les trous 5 avec les tiges ou dépôts conducteurs 4 sont positionnés en regard d'une surface intérieure ou inférieure du film isolant monté sur le substrat de base 2. De préférence le nombre de tiges conductrices 4 est égal au nombre d'électrodes des touches capacitives prévues sur le film isolant. Si 12 touches capacitives sont prévues, il faut 12 trous 5 et 12 tiges conductrices 4 ou dépôts conducteurs dans les trous. De préférence, les trous 5 et les tiges conductrices 4 sont disposés sur une ligne, qui peut se trouver parallèle et à proximité d'un côté du substrat de base. La dimension intérieure des trous correspond à la dimension extérieure des tiges conductrices ou les dépôts conducteurs, qui occupent entièrement les trous. Les trous sont de diamètre par exemple inférieur à 1 mm et sont régulièrement espacés les uns des autres. Les tiges conductrices ou les dépôts conducteurs 4 débordent légèrement de chaque côté des trous pour faciliter la connexion électrique des tiges ou dépôts conducteurs.

Le dispositif de connexion permet donc de connecter électriquement une portion de connexion du film isolant, qui comprend des plages conductrices reliées par des pistes conductrices aux électrodes transparentes des touches capacitives. De préférence, les électrodes, les pistes conductrices et les plages conductrices sont disposées sur une surface intérieure ou inférieure du film isolant 3 pour être en regard de la surface extérieure du substrat de base et faciliter la connexion électrique au dispositif de connexion 4, 5.

Il est à noter qu'il peut être prévu un autre type de dispositif de connexion pour connecter électriquement les électrodes des touches capacitives à un circuit électronique de traitement dans la boîte de montre. Des rainures verticales sur un bord du substrat de base 2 peuvent être réalisées et des dépôts conducteurs par exemple en ITO peuvent être effectués dans les rainures. Les rainures sont de dimension identique et régulièrement espacées, et chaque dépôt conducteur peut être relié électriquement à l'électrode correspondante du verre à touches capacitives terminé. Il peut encore être imaginé que le film isolant à touches capacitives se termine par une languette à plages de connexion, qui sont reliées chacune à une électrode correspondante, afin de replier la languette sur un bord du substrat de base pour venir connecter un connecteur électrique dans la boîte de montre.

La figure 2 représente en détail une vue tridimensionnelle et en éclaté des différents éléments du verre 1 à touches capacitives d'une première forme d'exécution. Comme on peut le remarquer, il est prévu un ensemble 3 de films ou couches à fixer sur la surface extérieure du substrat de base 2. Cependant dans un cas simple, il est clair qu'il peut n'être prévu qu'un film isolant 11 à fixer par collage ou laminage à chaud sur la surface extérieure du substrat de base 2. Le film isolant 11 porte des électrodes transparentes 13 de préférence sur une surface intérieure du film en regard de la surface extérieure du substrat de base 2. Il peut être prévu 12 électrodes transparentes 13 régulièrement espacées par série de 3 électrodes sur la surface intérieure du film isolant 11. Toutes les électrodes transparentes des touches capacitives peuvent être de dimension équivalente afin d'occuper la majeure partie de la surface intérieure du film isolant 11. Des pistes conductrices relient les électrodes transparentes à des plages de connexion du film isolant pour établir une connexion au dispositif de connexion 4, 5. Les pistes conductrices, les électrodes et les plages de connexion, qui peuvent être toutes transparentes, sont réalisées par gravure chimique d'une couche d'oxyde conducteur (ITO).

Selon la figure 2, il peut être prévu en dessus du film isolant 11 de disposer un film adhésif du type OCA 14 et encore au-dessus un film de décoration 16. Chaque film ou couche 11, 14, 16 peut être de dimension identique pour pouvoir être facilement guidé par le bord périphérique 21 du substrat de base 2 lors de leur montage. Le film isolant 11, le film adhésif 14 et le film isolant de décoration 16 peuvent être fixés les uns aux autres avant de monter l'ensemble de films ou couches 3 sur la surface supérieure du substrat de base. Cependant de préférence comme chaque film est de dimension adaptée pour pouvoir être facilement guidé par le bord périphérique 21 lors de leur montage, chaque film est monté successivement depuis la surface supérieure du substrat de base 2. Une fois le montage des films terminés, il peut être effectué un laminage à chaud pour fixer notamment le film isolant 11 au film de décoration 16 par l'intermédiaire du film d'adhésif 14. Le film isolant peut être simplement collé sur la surface supérieure du substrat de base 2 avec les plages de connexion en contact direct avec les tiges conductrices 4 ou dépôts conducteurs débouchant des trous 5 du dispositif de connexion.

Il est à noter que le dispositif de connexion 4, 5 peut être réalisé dans le substrat de base 2 avant le montage du ou des films 11, 14, 16 sur la surface supérieure du substrat de base. Cependant le dispositif de connexion peut aussi être réalisé après le montage des films 11, 14, 16 notamment l'insertion des tiges conductrices 4 dans les trous 5 ou les dépôts conducteurs dans les trous. Ces dépôts conducteurs peuvent être obtenus par gravure d'une couche d'ITO ou par une pâte métallique ou par un matériau métallique conducteur, tout comme les tiges conductrices.

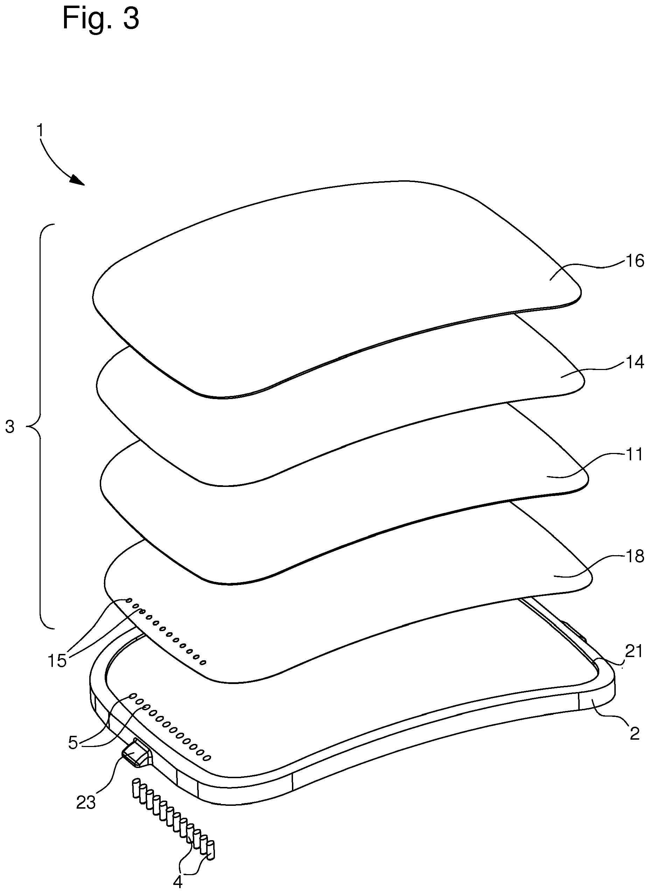

La figure 3 représente en détail une vue tridimensionnelle et en éclaté des différents éléments du verre 1 à touches capacitives d'une seconde forme d'exécution. A la différence de la première forme d'exécution présentée en regard à la figure 2, il est prévu ici un autre film adhésif 18, qui est disposé entre le film isolant 11, qui porte les touches capacitives 13, et la surface supérieure du substrat de base 2. Cet autre film adhésif 18 comprend un agencement de trous adaptés pour venir exactement sur les trous conducteurs 4, 5 du substrat de base 2. Ainsi après avoir disposé par exemple tous les films les uns sur les autres au-dessus de la surface extérieure du substrat de base, il peut être effectué un laminage à chaud de l'ensemble de films permettant aux films adhésifs de bien fixer l'ensemble de films sur le substrat de base tout en étant guidé par le bord périphérique 21 du substrat de base 2.

Bien entendu comme indiqué en référence à la figure 2, il peut être réalisé les trous 5 avec les tiges conductrices 4 ou les dépôts conducteurs dans le substrat de base 2 avant ou après le montage de l'ensemble de films. Il peut par exemple être effectué tout d'abord les trous 5 dans le substrat de base, puis le placement de chaque film 11, 14, 16, 18 successivement sur le substrat de base, leur fixation par laminage à chaud et finalement insérer les tiges conductrices 4 dans les trous 5 ou effectuer un dépôt métallique ou d'ITO dans les trous 5.

Une fois que le verre 1 à touches capacitives est terminé des première et seconde formes d'exécution présentées en regard des figures 2 et 3, une connexion électrique doit être encore effectuée au montage du verre dans la boîte de montre. Pour ce faire, il est généralement prévu un connecteur notamment du type Zébra, qui traverse le cadran de montre, pour relier des bornes de connexion d'une plaque à circuit imprimé portant un circuit de traitement, et pour relier les trous conducteurs 4 débouchant en dessous du verre 1.

A partir de la description qui vient d'être faite, plusieurs variantes du verre à touches capacitives pour un instrument électronique portable, et son procédé de fabrication peuvent être conçues par l'homme du métier sans sortir du cadre de l'invention définie par les revendications. Il peut être prévu de placer les électrodes transparentes sur une surface supérieure du film isolant et prévoir des trous métallisés à travers le film isolant pour venir connecter les trous métallisés du substrat de base. Plusieurs films isolants à touches capacitives peuvent être prévus et disposés fixés les uns sur les autres tout en garantissant une connexion aux trous métallisés du substrat de base. Il peut être prévu tout d'abord de fixer le film isolant sur la surface extérieure du substrat de base, d'introduire les tiges conductrices dans les trous du substrat pour la connexion aux électrodes du film isolant, puis finalement de fixer les autres films au-dessus du film isolant.

## Revendications

1. Verre (1) à touches capacitives pour un instrument électronique portable, le verre comprenant un substrat de base (2), et au moins un film isolant (3, 11), qui est muni d'électrodes (13) des touches capacitives, **caractérisé en ce que** le film isolant est fixé sur une surface extérieure du substrat de base (2), et un dispositif de connexion (4, 5) est réalisé dans ou à travers le substrat de base pour relier électriquement une portion de connexion du film isolant, qui comprend des plages conductrices reliées par des pistes conductrices aux électrodes transparentes des touches capacitives, et pour être relié à un circuit de traitement dans l'instrument électronique portable, qui est équipé du verre (1), **en ce que** le film isolant (3, 11) est un film flexible avec les électrodes (13) disposées uniquement sur une première surface du film isolant, qui est fixée sur la surface extérieure du substrat de base (2), **en ce que** la surface extérieure du substrat de base (2) comprend un bord périphérique (21), **en ce que** le film isolant (3, 11) est fixé sur la surface extérieure du substrat de base (2) à l'intérieur du bord périphérique (21), et **en ce que** la dimension du bord périphérique est adaptée à la dimension périphérique du film isolant (3, 11) pour faciliter le guidage et le montage du film isolant sur la surface extérieure du substrat de base.

2. Verre (1) à touches capacitives selon la revendication 1, **caractérisé en ce que** le film isolant (3, 11) est fixé sur la surface extérieure du substrat de base (2) par l'intermédiaire d'un premier film adhésif (18) suite à une opération de laminage à chaud.

3. Verre (1) à touches capacitives selon la revendication 1, **caractérisé en ce que** le verre comprend un film de décoration (16), qui est fixé sur le film isolant (11).

4. Verre (1) à touches capacitives selon la revendication 3, **caractérisé en ce que** le film de décoration (16) est fixé sur le film isolant par l'intermédiaire d'un second film adhésif (14) suite à une opération de laminage à chaud.

5. Verre (1) à touches capacitives selon la revendication 1, **caractérisé en ce que** le verre comprend le film isolant (11) fixé sur la surface extérieure du substrat de base (2) par l'intermédiaire d'un premier film adhésif (18), et un film de décoration (16) fixé sur le film isolant (11) par l'intermédiaire d'un second film adhésif (14), et **en ce que** l'ensemble constitué du premier film adhésif (18), du film isolant (11), du second film adhésif et du film de décoration sont fixés sur la surface extérieure du substrat de base suite à une opération de laminage à chaud.

6. Verre (1) à touches capacitives selon la revendication 5, **caractérisé en ce que** la dimension de chaque film est identique, et en ce le bord périphérique (21) est dimensionné en fonction de la dimension périphérique de l'ensemble des films pour faciliter le guidage et le montage des films sur la surface extérieure du substrat de base.

7. Verre (1) à touches capacitives selon la revendication 6, **caractérisé en ce que** l'épaisseur du bord périphérique (21) correspond à l'épaisseur de l'ensemble des films pour former un verre d'épaisseur uniforme.

8. Verre (1) à touches capacitives selon la revendication 1, **caractérisé en ce que** le dispositif de connexion comprend des tiges conductrices ou dépôts conducteurs (4) disposés dans une série de trous (5) réalisés à travers le substrat de base ou dans une série de rainures verticales réalisées sur un bord du substrat de base (2).

9. Verre (1) à touches capacitives selon la revendication 8, **caractérisé en ce que** le nombre de trous (5) ou de rainures, et de tiges ou dépôts conducteurs (4) correspond au nombre d'électrodes des touches capacitives, et **en ce que** les électrodes (13) sur la première surface du film isolant, sont reliées par les pistes conductrices respectives aux plages conductrices de la portion de connexion, les plages conductrices étant reliées directement aux tiges ou dépôts conducteurs.

10. Verre (1) à touches capacitives selon la revendication 9, **caractérisé en ce que** les trous (5) avec les tiges ou dépôts conducteurs (4) sont disposés sur une ligne et de manière similaire à l'agencement des plages conductrices de la portion de connexion du film isolant pour opérer une connexion électrique.

11. Verre (1) à touches capacitives selon la revendication 10, **caractérisé en ce que** les trous (5) avec les tiges ou dépôts conducteurs (4) sont de dimension similaire et régulièrement espacés.

12. Procédé de fabrication d'un verre (1) à touches capacitives pour un instrument électronique portable selon l'une des revendications précédentes, **caractérisé en ce qu'**il comprend les étapes de :
- réaliser le dispositif de connexion (4, 5) dans ou à travers le substrat de base (2), et
- fixer le film isolant (3, 11) sur la surface extérieure du substrat de base, avant ou après avoir réalisé le dispositif de connexion (4, 5) dans le substrat de base (2), le film isolant comprenant sur la première surface, les électrodes (13), qui sont reliées par les pistes conductrices respectives aux plages conductrices de la portion de connexion, la portion de connexion étant directement reliée au dispositif de connexion, et pour lequel le substrat de base (2) comprend le bord périphérique (21) de dimension adaptée à la dimension périphérique du film isolant, où le film isolant (3, 11) est disposé et guidé par le bord périphérique lors de son montage sur la surface extérieure du substrat de base.

13. Procédé de fabrication d'un verre (1) à touches capacitives selon la revendication 12, **caractérisé en ce que** le film isolant est fixé sur la surface extérieure du substrat de base par l'intermédiaire d'un premier film adhésif (18) et au moyen d'un laminage à chaud.

14. Procédé de fabrication d'un verre (1) à touches capacitives selon l'une des revendications 12 et 13, **caractérisé en ce qu'**un film de décoration (16) est fixé sur le film isolant (3, 11) avant ou après avoir réalisé le dispositif de connexion dans le substrat de base (2).

15. Procédé de fabrication d'un verre (1) à touches capacitives selon la revendication 14, **caractérisé en ce que** le film de décoration (16) est fixé sur le film isolant par l'intermédiaire d'un second film adhésif (14) et au moyen d'un laminage à chaud.

16. Procédé de fabrication d'un verre (1) à touches capacitives selon la revendication 12, **caractérisé en ce que** pour la réalisation du dispositif de connexion, des tiges conductrices ou des dépôts conducteurs (4) sont réalisés dans des trous (5) du substrat de base (2).

## Patentansprüche

1. Kapazitive Touchscreen-Glasscheibe (1) für ein tragbares elektronisches Gerät, wobei das Glas ein Grundsubstrat (2) und mindestens eine Isolierfolie (3, 11) umfasst, die mit Elektroden (13) der kapazitiven Tasten versehen ist, **dadurch gekennzeichnet, dass** die Isolierfolie auf einer Außenfläche des Grundsubstrats (2) befestigt ist und eine Anschlussvorrichtung (4, 5) in dem Grundsubstrat oder durch es hindurch ausgebildet ist, um einen Anschlussabschnitt der Isolierfolie, der leitende Bereiche aufweist, die durch Leiterbahnen mit den transparenten Elektroden der kapazitiven Tasten verbunden sind, elektrisch zu verbinden und um mit einer Verarbeitungsschaltung in dem tragbaren elektronischen Gerät, das mit dem Glas (1) ausgerüstet ist, verbunden zu werden, dass die Isolierfolie (3, 11) eine flexible Folie ist mit ausschließlich auf einer ersten Oberfläche der Isolierfolie angeordneten Elektroden (13), die an der Außenfläche des Grundsubstrats (2) befestigt ist, dass die Außenfläche des Grundsubstrats (2) einen Umfangsrand (21) aufweist, dass die Isolierfolie (3, 11) an der Außenfläche des Grundsubstrats (2) innerhalb des Umfangsrandes (21) befestigt ist und dass die Abmessung des Umfangsrandes an die Umfangsabmessung der Isolierfolie (3, 11) angepasst ist, um die Führung und die Montage der Isolierfolie auf der Außenfläche des Grundsubstrats zu erleichtern.

2. Kapazitive Touchscreen-Glasscheibe (1) nach Anspruch 1, **dadurch gekennzeichnet, dass** die Isolierfolie (3, 11) an der Außenfläche des Grundsubstrats (2) mittels einer ersten Klebefolie (18) nach einem Warmwalzvorgang befestigt ist.

3. Kapazitive Touchscreen-Glasscheibe (1) nach Anspruch 1, **dadurch gekennzeichnet, dass** das Glas eine Dekorfolie (16) aufweist, die auf der Isolierfolie (11) befestigt ist.

4. Kapazitive Touchscreen-Glasscheibe (1) nach Anspruch 3, **dadurch gekennzeichnet, dass** die Dekorfolie (16) auf der Isolierfolie mittels einer zweiten Klebefolie (14) nach einem Warmwalzvorgang befestigt ist.

5. Kapazitive Touchscreen-Glasscheibe (1) nach Anspruch 1, **dadurch gekennzeichnet, dass** das Glas die Isolierfolie (11), die an der Außenfläche des Grundsubstrats (2) mittels einer ersten Klebefolie (18) befestigt ist, und eine Dekorfolie (16), die auf der Isolierfolie (11) mittels einer zweiten Klebefolie (14) befestigt ist, umfasst, und dass die Gesamtheit, die aus der ersten Klebefolie (18), der Isolierfolie (11), der zweiten Klebefolie und der Dekorfolie gebildet ist, auf der Außenfläche des Grundsubstrats nach einem Warmwalzvorgang befestigt ist.

6. Kapazitive Touchscreen-Glasscheibe (1) nach Anspruch 5, **dadurch gekennzeichnet, dass** die Abmessung jeder Folie gleich ist und dass der Umfangsrand (21) abhängig von der Umfangsabmessung der Gesamtheit der Folien bemessen ist, um die Führung und die Montage der Folien auf der Außenfläche des Grundsubstrats zu erleichtern.

7. Kapazitive Touchscreen-Glasscheibe (1) nach Anspruch 6, **dadurch gekennzeichnet, dass** die Dicke des Umfangsrandes (21) der Dicke der Gesamtheit der Folien entspricht, um ein Glas mit gleichmäßiger Dicke zu bilden.

8. Kapazitive Touchscreen-Glasscheibe (1) nach Anspruch 1, **dadurch gekennzeichnet, dass** die Anschlussvorrichtung leitende Stifte oder leitfähige Ablagerungen (4) umfasst, die in einer Reihe von Löchern (5), die durch das Grundsubstrat hindurch ausgebildet sind, oder in einer Reihe von vertikalen Rillen angeordnet sind, die am Rand des Grundsubstrats (2) ausgebildet sind.

9. Kapazitive Touchscreen-Glasscheibe (1) nach Anspruch 8, **dadurch gekennzeichnet, dass** die Anzahl von Löchern (5) oder Rillen und von Stiften oder leitfähigen Ablagerungen (4) der Anzahl von Elektroden der kapazitiven Tasten entspricht und dass die Elektroden (13) auf der ersten Oberfläche der Isolierfolie durch jeweilige Leiterbahnen mit den leitenden Bereichen des Anschlussabschnitts verbunden sind, wobei die leitenden Bereiche direkt mit den Stiften oder leitfähigen Ablagerungen verbunden sind.

10. Kapazitive Touchscreen-Glasscheibe (1) nach Anspruch 9, **dadurch gekennzeichnet, dass** die Löcher (5) mit den Stiften oder leitenden Ablagerungen (4) auf einer Linie und auf eine Weise angeordnet sind, die der Anordnung der leitenden Bereiche des Anschlussabschnitts der Isolierfolie ähnlich ist, um eine elektrische Verbindung herzustellen.

11. Kapazitive Touchscreen-Glasscheibe (1) nach Anspruch 10, **dadurch gekennzeichnet, dass** die Löcher (5) mit den Stiften oder leitenden Ablagerungen (4) eine ähnliche Abmessung haben und regelmäßig beabstandet sind.

12. Verfahren für die Herstellung einer kapazitiven Touchscreen-Glasscheibe (1) für ein tragbares elektronisches Gerät nach einem der vorhergehenden Ansprüche, **dadurch gekennzeichnet, dass** es die Schritte umfasst:
- Ausbilden der Anschlussvorrichtung (4, 5) in dem Grundsubstrat (2) oder durch es hindurch und
- Befestigen der Isolierfolie (3, 11) an der Außenfläche des Grundsubstrats, vor oder nach dem Ausbilden der Anschlussvorrichtung (4, 5) in dem Grundsubstrat (2), wobei die Isolierfolie auf der ersten Oberfläche die Elektroden (13) aufweist, die durch die jeweiligen Leiterbahnen mit den leitenden Bereichen des Anschlussabschnitts verbunden sind, wobei der Anschlussabschnitt direkt mit der Anschlussvorrichtung verbunden ist, wobei das Grundsubstrat (2) einen Umfangsrand (21) mit einer an die Umfangsabmessung der Isolierfolie angepassten Abmessung aufweist, wobei die Isolierfolie (3, 11) bei ihrer Montage auf der Außenfläche des Grundsubstrats durch den Umfangsrand angeordnet und geführt wird.

13. Verfahren für die Herstellung einer kapazitiven Touchscreen-Glasscheibe (1) nach Anspruch 12, **dadurch gekennzeichnet, dass** die Isolierfolie an der Außenfläche des Grundsubstrats mittels einer ersten Klebefolie (18) und mittels eines Warmwalzvorgangs befestigt wird.

14. Verfahren für die Herstellung einer kapazitiven Touchscreen-Glasscheibe (1) nach einem der Ansprüche 12 und 13, **dadurch gekennzeichnet, dass** eine Dekorfolie (16) auf der Isolierfolie (3, 11) vor oder nach dem Ausbilden der Anschlussvorrichtung in dem Grundsubstrat (2) befestigt wird.

15. Verfahren für die Herstellung einer kapazitiven Touchscreen-Glasscheibe (1) nach Anspruch 14, **dadurch gekennzeichnet, dass** die Dekorfolie (16) an der Isolierfolie mittels einer zweiten Klebefolie (14) und eines Warmwalzvorgangs befestigt wird.

16. Verfahren für die Herstellung einer kapazitiven Touchscreen-Glasscheibe (1) nach Anspruch 12, **dadurch gekennzeichnet, dass** für die Ausbildung der Anschlussvorrichtung leitende Stifte oder leitfähige Ablagerungen (4) in den Löchern (5) des Grundsubstrats (2) ausgebildet werden.

## Claims

1. Glass (1) with capacitive keys for a portable electronic instrument, the glass comprising a base substrate (2), and at least one insulating film (3, 11), which is provided with electrodes (13) for the capacitive keys, **characterized in that** the insulating film is attached to an outer surface of the base substrate (2), and an interconnect device (4, 5) is formed in or through the base substrate in order to electrically connect an interconnect portion of the insulating film, which comprises conductive lands that are connected by conductive tracks to the transparent electrodes for the capacitive keys, and in order to be connected to a processing circuit in the portable electronic instrument, which is provided with the glass (1), **in that** the insulating film (3, 11) is a flexible film with the electrodes (13) arranged only on a first surface of the insulating film, which surface is attached to the outer surface of the base substrate (2), **in that** the outer surface of the base substrate (2) comprises a peripheral edge (21), **in that** the insulating film (3, 11) is attached to the outer surface of the base substrate (2) inside the peripheral edge (21), and **in that** the size of the peripheral edge is matched to the peripheral size of the insulating film (3, 11) in order to facilitate guiding and mounting the insulating film on the outer surface of the base substrate.

2. Glass (1) with capacitive keys according to claim 1, **characterized in that** the insulating film (3, 11) is attached to the outer surface of the base substrate (2) via a first adhesive film (18) following a hot-rolling operation.

3. Glass (1) with capacitive keys according to claim 1, **characterized in that** the glass comprises a decorative film (16), which is attached to the insulating film (11).

4. Glass (1) with capacitive keys according to claim 3, **characterized in that** the decorative film (16) is attached to the insulating film via a second adhesive film (14) following a hot-rolling operation.

5. Glass (1) with capacitive keys according to claim 1, **characterized in that** the glass comprises the insulating film (11) that is attached to the outer surface of the base substrate (2) via a first adhesive film (18), and a decorative film (16) that is attached to the insulating film (11) via a second adhesive film (14), and **in that** the set consisting of the first adhesive film (18), of the insulating film (11), of the second adhesive film and of the decorative film is attached to the outer surface of the base substrate following a hot-rolling operation.

6. Glass (1) with capacitive keys according to claim 5, **characterized in that** the size of each film is identical, and **in that** the peripheral edge (21) is sized according to the peripheral size of the set of films in order to facilitate guiding and mounting the films on the outer surface of the base substrate.

7. Glass (1) with capacitive keys according to claim 6, **characterized in that** the thickness of the peripheral edge (21) corresponds to the thickness of the set of films so as to form a glass of uniform thickness.

8. Glass (1) with capacitive keys according to claim 1, **characterized in that** the interconnect device comprises conductive rods or conductive deposits (4) that are arranged in a series of holes (5) made through the base substrate or in a series of vertical grooves made in an edge of the base substrate (2).

9. Glass (1) with capacitive keys according to claim 8, **characterized in that** the number of holes (5) or grooves, and of rods or conductive deposits (4), corresponds to the number of electrodes for the capacitive keys, and **in that** the electrodes (13) on the first surface of the insulating film are connected by the respective conductive tracks to the conductive lands of the interconnect portion, the conductive lands being connected directly to the rods or conductive deposits.

10. Glass (1) with capacitive keys according to claim 9, **characterized in that** the holes (5) with the rods or conductive deposits (4) are arranged in a line and similarly to the arrangement of the conductive lands of the interconnect portion of the insulating film so as to effect an electrical connection.

11. Glass (1) with capacitive keys according to claim 10, **characterized in that** the holes (5) with the rods or conductive deposits (4) are similar in size and spaced regularly apart.

12. Process for manufacturing a glass (1) with capacitive keys for a portable electronic instrument according to one of the preceding claims, **characterized in that** it comprises the steps of:
- producing the interconnect device (4, 5) in or through the base substrate (2); and
- attaching the insulating film (3, 11) to the outer surface of the base substrate, before or after having produced the interconnect device (4, 5) in the base substrate (2), the insulating film comprising, on the first surface, the electrodes (13), which are connected by the respective conductive tracks to the conductive lands of the interconnect portion, the interconnect portion being directly connected to the interconnect device, and for which the base substrate (2) comprises the peripheral edge (21), the size of which is matched to the peripheral size of the insulating film, where the insulating film (3, 11) is positioned and guided by the peripheral edge when it is being mounted on the outer surface of the base substrate.

13. Process for manufacturing a glass (1) with capacitive keys according to claim 12, **characterized in that** the insulating film is attached to the outer surface of the base substrate via a first adhesive film (18) and by means of hot rolling.

14. Process for manufacturing a glass (1) with capacitive keys according to either of claims 12 and 13, **characterized in that** a decorative film (16) is attached to the insulating film (3, 11) before or after the interconnect device has been produced in the base substrate (2).

15. Process for manufacturing a glass (1) with capacitive keys according to claim 14, **characterized in that** the decorative film (16) is attached to the insulating film via a second adhesive film (14) and by means of hot rolling.

16. Process for manufacturing a glass (1) with capacitive keys according to claim 12, **characterized in that**, to produce the interconnect device, conductive rods or conductive deposits (4) are formed in holes (5) in the base substrate (2).
